# EUROPEAN PATENT SPECIFICATION

(11) **EP 0 630 108 B1**
(45) Date of publication and mention of the grant of the patent: **28.10.1998**
(21) Application number: 94304002.2
(22) Date of filing: 03.06.1994
(51) Int. Cl.: H03H 17/02

(54) **A method of expanding the frequency range of a digital audio signal**
Verfahren zum Expandieren des Frequenzbereichs eines digitalen audio Signals
Procédé pour l'extension de la gamme de fréquences d'un signal audio numérique

(30) Priority: 03.06.1993 JP 133067/93
(43) Date of publication of application: 21.12.1994
(73) Proprietor: NEC CORPORATION, Tokyo (JP)
(72) Inventor: Hasegawa, Satoshi, c/o NEC Corporation, Tokyo (JP)
(74) Representative: Orchard, Oliver John

(56) References cited:
- TECHNOLOGIES TODAY AND TOMORROW, NEW ORLEANS, APRIL 1 - 4, 1990, vol. 1 OF 3, 1 April 1990 INSTITUTE OF ELECTRICAL AND ELECTRONICS ENGINEERS, pages 233-237, XP 000203101 HENRIQUEZ J A ET AL 'SAMPLE RATE CONVERSION FOR DIGITAL AUDIO PROCESSING'
- PATENT ABSTRACTS OF JAPAN vol. 017 no. 209 (E-1355) ,23 April 1993 & JP-A-04 348686 (KOUBE NIHON DENKI SOFUTOUEA KK) 3 December 1992,

## Description

### BACKGROUND OF THE INVENTION

### Field of the Invention

The present invention relates generally to improvements in audio signal processing, and more specifically to a method of expanding a frequency range of a digital audio signal without increasing a sampling rate which has been utilized for converting an original analog audio signal to the digital audio signal.

### Description of the Prior Art

With the advent of recent developments in digital signal processing, it is often the case that an analog audio signal such as a speech signal is converted into a digital signal and then is stored, for later use, in an appropriate storage medium such a RAM (random access memory), a magnetic tape, etc.

Before turning to the present invention it is deemed advantageous to briefly discuss a known method wherein a digital audio signal stored in storage medium is read out thereof for driving a speaker after being converted into the corresponding analog signal.

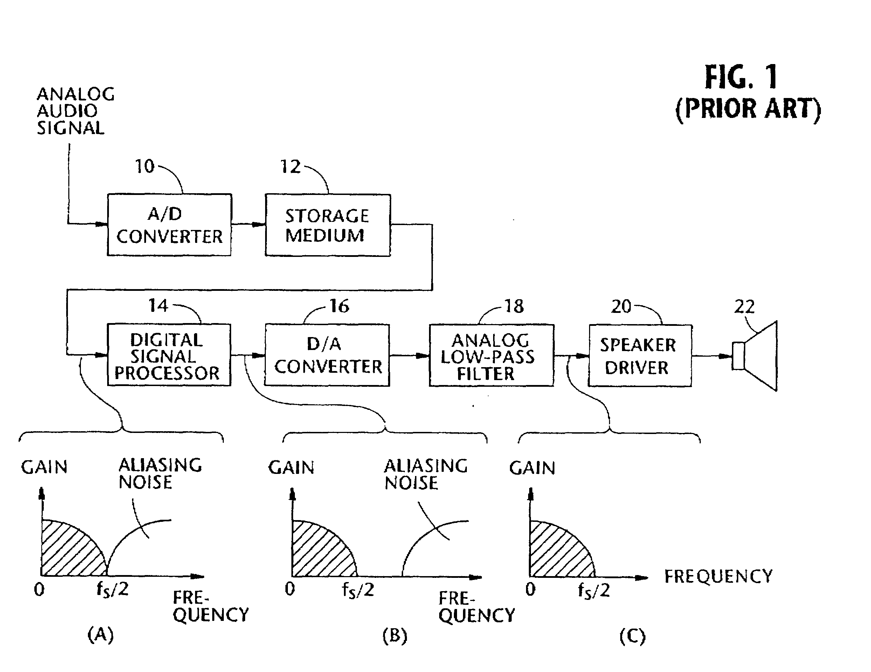

Fig. 1 is a diagram schematically showing such a known technique. The arrangement of Fig. 1 includes a plurality of functional blocks together with three sketches each of which schematically illustrates spectrum distribution of a digital signal appearing at the functional blocks.

As shown in Fig. 1, an analog-to-digital (A/D) converter 10 is supplied with an analog signal such as a speech signal. The A/D converter 10 samples the incoming analog signal and then quantizes the sampled values as is well known in the art. A digital audio signal thus obtained is stored in a suitable storage medium 12 such as a RAM. Representing a sampling rate as fₛ, a sampling theorem tells us that the digital signal stored in the storage medium 12 has a frequency spectrum (frequency range) extending from 0Hz to fₛ/2.

Therefore, if the A/D converter 10 samples the incoming audio signal at a sampling rate of 8kHz, then the digital signal stored has a frequency spectrum ranging from 0Hz to 4kHz (= fₛ/2). Further, the digital signal stored in the storage medium includes aliasing noises inherently incurred during the sampling, as is known in the art.

A digital audio signal retrieved from the storage medium 12 is applied to a digital signal processor 14. The spectrum of the digital signal is schematically shown in a sketch (A) of Fig. 1. As shown, the digital audio signal (hatched portion) has a frequency range from 0Hz to fₛ/2 and accompanying aliasing noises. The spectra of the digital signal and the noises are symmetrical with respect to the frequency fₛ/2.

The digital signal processor 14 operates such as to shift the aliasing noises toward a higher frequency range. In other words, the processor 14 moves only the aliasing noises away from fₛ/2. Thereafter, the output of the digital signal processor 14 is applied to a digital-to-analog converter 16 wherein the digital signal is converted into the corresponding analog signal. Subsequently, an analog low-pass filter 18 allows the audio signal (hatched portion) to pass therethrough. Thus, the aliasing noises can be blocked at the low-pass filter 18. The reproduced analog signal is applied to a speaker 22 via a speaker driver 20 which includes an audio frequency amplifier as is known in the art.

It has been assumed that the digital audio signal has the frequency range from 0Hz to 4kHz. If it is desired to reproduce a sound at the speaker 22 in a more natural manner, the frequency range of the stored digital signal should be expanded up to a higher frequency (for example, about 8kHz). This implies that the sampling rate should be increased to 16kHz (8kHz × 2).

It is sometimes desirable to expand an audio frequency range without increasing a sampling rate. However, no technique has been proposed for effectively expanding a digital audio frequency range without increasing a sampling rate.

### SUMMARY OF THE INVENTION

It is therefore an object of the present invention to provide a method of expanding a frequency range of a digital audio signal without increasing a sampling rate which is used to convert an original analog signal into the digital audio signal.

In brief, the above object is achieved by techniques wherein a frequency range of a digital audio signal is effectively expanded without increasing a sampling frequency which has been used for generating the digital audio signal. Firstly, the digital audio signal is divided into first and second digital audio signals. The first digital audio signal is delayed by a predetermined time duration in order to be combined, at a later time, with the second digital audio signal which is to be subject to digital processing. The second digital audio signal undergoes band-pass filtering. Thereafter, the frequency range of the second digital audio signal which has been band-pass filtered, is expanded. Following this, the second digital audio signal whose frequency range has been expanded is combined with the first digital audio signal which has been delayed. Thus, the digital audio signal is expanded in terms of its frequency range.

More specifically, a first aspect of the present invention resides in a method of expanding a frequency range of a digital audio signal which has been sampled by a frequency fₛ, the digital audio signal having a frequency range whose upper frequency is defined by a frequency fₛ/2, the method comprising the steps of: (a) splitting the digital audio signal into first and second digital audio signals; (b) delaying the first digital audio signal by a predetermined time duration; (c) bandpass filtering the second digital audio signal, the second digital audio signal, after being subjected to the band-pass filtering, having a first frequency range defined by frequencies f₁ and f₂ (0<f₁<f₂≦fₛ); (d) expanding the first frequency range of the second digital audio signal over a second frequency range; (e) combining the first and second digital audio signals for generating a third digital audio signal with an expanded frequency range.

### BRIEF DESCRIPTION OF THE DRAWINGS

The features and advantages of the present invention will become more clearly appreciated from the following description taken in conjunction with the accompanying drawings in which like elements are denoted by like reference numerals and in which:
Fig. 1 is an illustration schematically showing a known audio signal processing technique, having referred to in the opening paragraphs of the instant disclosure; and
Fig. 2 is a diagram schematically showing a plurality of functional blocks and sketches provided for a better understanding of the present invention.

### DETAILED DESCRIPTION OF THE PREFERRED EMBODIMENTS

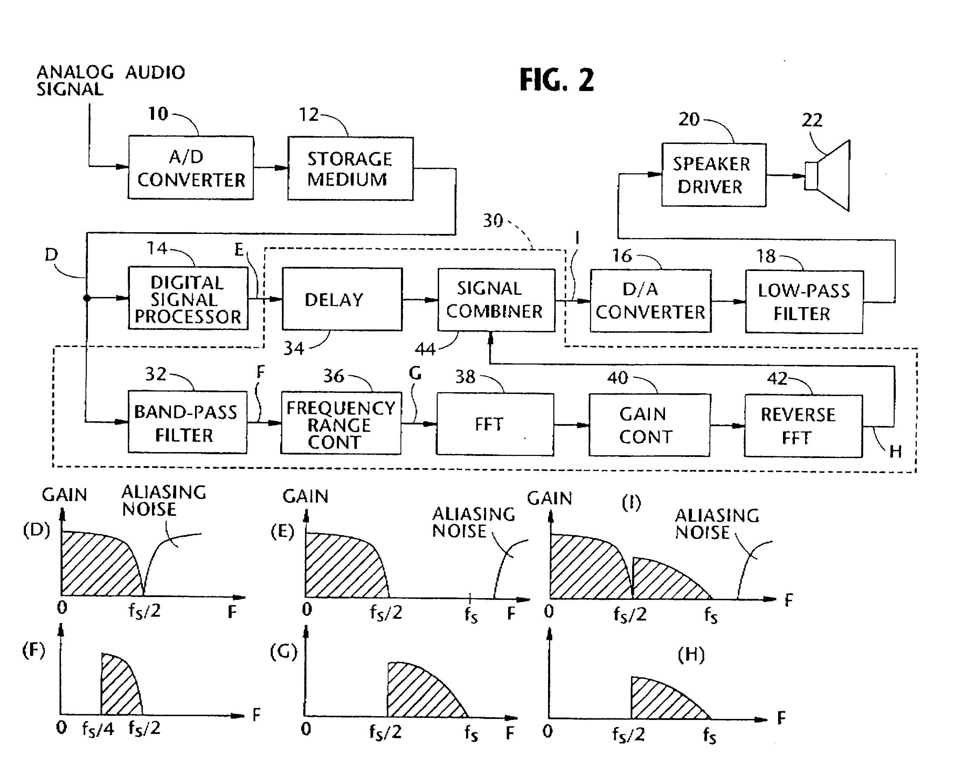

Reference is now made to Fig. 2, wherein a plurality of functional blocks for use in discussing the present invention are shown. Fig. 2 further illustrates six sketches (D)-(H) each showing spectrum distribution of digital signals appearing at the blocks of Fig. 2.

The arrangement of the blocks of Fig. 2 differs from that of Fig. 1 in that the former arrangement further includes a frequency range expander 30 enclosed by a dashed line.

Each of the blocks of the frequency range expander 30 is well known to one of ordinary skill in the art. The present invention resides in an improved method which can be achieved by combining such known functional blocks.

As mentioned in connection with the prior art, a digital audio signal is stored in the storage medium 12 such as a RAM (random access memory), a magnetic tape, etc. Further, the sampling rate fₛ at the A/D converter 10 is 8kHz merely by way of example. Thus, as before, the digital signal stored in the storage medium 12 has a frequency range from 0Hz to 4kHz (=fₛ/2).

In Fig. 2, the sketches (D)-(I) show spectrum distribution of corresponding digital signals D-I, respectively.

The digital audio signal D is retrieved from the storage medium 12 and then is applied to both the digital signal processor 14 and a band-pass filter 32 which forms part of the frequency range expander 30.

The spectrum of the digital signal D, which are shown in the sketch (D), is substantially the same as that shown in the sketch (A) of Fig. 1.

As in the prior art of Fig. 1, the digital signal processor 14 operates such as to shift the aliasing noises toward a higher frequency range. In this case, the aliasing noise is shifted above the sampling frequency fₛ as illustrated in the sketch (E). Thereafter, the output of the processor 14 is applied to a delay circuit 34. The delay circuit 34 is to delay the digital audio signal D by a time duration which is required for processing a digital signal at blocks 32, 36, 38, 40, and 42.

The band-pass filter 32 is to filter signal components between fₛ/4 and fₛ/2 of the digital signal D, as shown in the sketch (F).

The output F of the band-pass filter 32 is then applied to a frequency range controller 36 wherein the frequency range from fₛ/4 to fₛ/2 is doubled in this particular case. Therefore, the output G of the frequency range controller 36 exhibits a frequency range shown in the sketch (G).

Following this, the output G of the controller 36 is applied to a FFT (Fast Fourier Transformer) 38 wherein a time domain signal is changed to a frequency domain signal in order to be processed in the next stage, viz., a gain controller 40.

The gain controller 40 operates such as to regulate the signal gain over the frequency range (from fₛ/2 to fₛ) of the signal G in order to improve the sense of hearing when the reproduced analog signal drives the speaker 22. As is well known in the art, the response of a human ear to sound depends on the frequency of the sound as well as its intensity. The ear is more sensitive to some frequencies than to others. The ear is most sensitive near 4kHz. At frequencies other than this, the sound must be made more intense before it is audible. The gain controller 40 is to regulate the audio signal gains of the digital signal applied from the FFT to appropriate levels.

Subsequently, the output of the gain controller 40 is restored to a time domain signal using a reverse FFT 42. The spectrum of the output H of the reverse FFT 42 is schematically shown in the sketch H.

The operations of the FFT 38 and the reverse FFT 42 are known in the art and hence further discussion thereof will be omitted for brevity.

A signal combiner 44 is supplied with the two outputs of the delay circuit 34 and the reverse FFT 42, and combines them as shown in the sketch (I). As mentioned above, the delay circuit 34 is to retard the output E of the digital signal processor 14 by a time duration which is required for completing the signal processing at the reverse FFT 42.

Thus, the output I of the signal combiner 44 has a frequency range extending from 0Hz to 8kHz (viz., the sampling rate fₛ) in this particular case.

The D/A converter 16 converts the digital output I into the corresponding analog signal. The low-pass filter 18 is designed such as to pass the analog signal components from 0Hz to 8kHz (viz., fₛ) and to block the aliasing noises. Thus, a more natural sound can be obtained from the speaker 22 as compared with the prior art without increasing the sampling frequency fₛ.

A goal of the present invention is to expand the frequency range of the output F of the filter 32 and then combine the delayed digital signal and the output H of the reverse FFT 42. Accordingly, it is understood that the present invention is in no way limited to the foregoing, the band-pass filter 32 passes the band-pass filtering of the digital signal to the frequency range from fₛ to fₛ/2. That is, such a band-pass filtering is merely exemplary.

It will be understood that although a particular embodiment, illustrative of the invention, has been described by way of example, variations and modifications thereof, as well as other embodiments, may be made within the scope of the appended claims.

## Claims

1. A method of expanding a frequency range of a digital audio signal which has been sampled by a frequency fₛ, said digital audio signal having a frequency range whose upper frequency is defined by a frequency fₛ/2, said method comprising the steps of:
(a) splitting said digital audio signal into first and second digital audio signals;
(b) delaying said first digital audio signal by a predetermined time duration;
(c) band-pass filtering said second digital audio signal, said second digital audio signal, after being subjected to the band-pass filtering, having a first frequency range defined by frequencies f₁ and f₂ (0<f₁<f₂≤fₛ);
(d) expanding said first frequency range of said second digital audio signal over a second frequency range;
(e) combining said first and second digital audio signals for generating a third digital audio signal with an expanded frequency range.

2. A method as claimed in claim 1, wherein said predetermined time duration corresponds to a time duration for which said third digital audio signal is generated after said digital audio signal is split in step (a).

3. A method as claimed in claim 1, further comprising a step of:
regulating gains of frequency components of said second digital audio signal after step (d).

4. A method as claimed in claim 1, wherein said frequency f₁ is equal to fₛ/4 and wherein said frequency f₂ is equal to fₛ/2.

5. A method as claimed in claim 1, wherein said second frequency range is defined by said frequencies fₛ/2 and fₛ.

6. A method as claimed in claim 1, further comprising steps of:
(f) shifting noise components, which are involved in said digital audio signal and which have been induced when issuing said digital audio signal by analog-to-digital conversion, up to a frequency higher than said frequency fₛ before said step (a);
(g) converting said third digital audio signal into a corresponding analog signal after said step (e); and
(h) low-pass filtering said analog signal such as to block said noise components.

## Patentansprüche

1. Verfahren zur Expansion eines Frequenzbereichs eines digitalen Audiosignals, welches mit einer Frequenz fₛ abgetastet wurde, wobei das digitale Audiosignal einen Frequenzbereich aufweist, dessen obere Frequenz durch eine Frequenz fₛ/2 bestimmt ist, das die Schritte aufweist:
(a) Aufteilen des digitalen Audiosignals in ein erstes und zweites digitales Audiosignal;
(b) Verzögern des ersten digitalen Audiosignals um eine vorbestimmte Zeitdauer;
(c) Bandpaßfiltern des zweiten digitalen Audiosignals, wobei das zweite digitale Audiosignal nach der Unterwerfung unter die Bandpaßfilterung einen ersten Frequenzbereich definiert von Frequenzen f₁ und f₂ (0 < f₁ < f₂ ≤ fₛ) aufweist;
(d) Expandieren des ersten Frequenzbereichs des zweiten digitalen Audiosignals über einen zweiten Frequenzbereich;
(e) Kombinieren des ersten und zweiten digitalen Audiosignals, um ein drittes digitales Audiosignal mit einem expandierten Frequenzbereich zu erzeugen.

2. Verfahren nach Anspruch 1, wobei die vorbestimmt Zeitdauer einer Zeitdauer entspricht, während welcher das dritte digitale Audiosignal erzeugt wird, nachdem das digitale Audiosignal in Schritt (a) aufgeteilt worden ist.

3. Verfahren nach Anspruch 1, ferner mit dem Schritt:
Regeln der Verstärkungen von Frequenzkomponenten des zweiten digitalen Audiosignals nach dem Schritt (d).

4. Verfahren nach Anspruch 1, wobei die Frequenz f₁ gleich fₛ/4 ist und wobei die Frequenz f₂ gleich fₛ/2 ist.

5. Verfahren nach Anspruch 1, wobei der zweite Frequenzbereich durch die Frequenzen fs/2 und fs definiert ist.

6. Verfahren nach Anspruch 1, ferner mit den Schritten:
(f) Verschieben von Störkomponenten, welche in dem digitalen Audiosignal enthalten sind und welche bei der Ausgabe des digitalen Audiosignal aus der Analog/Digital-Umwandlung induziert wurden, in einen Frequenzbereich höher als die Frequenz fₛ vor dem Schritt (a);
(g) Umwandeln des dritten digitalen Audiosignals in ein entsprechendes analoges Signal nach dem Schritt (e); und
(h) Tiefpaßfiltern des analogen Signals in der Weise, daß die Störkomponenten blockiert werden.

## Revendications

1. Procédé d'extension la plage de fréquences d'un signal audionumérique qui a été échantillonné en utilisant une fréquence fₛ, ledit signal audionumérique présentant une plage de fréquences dont la fréquence supérieure est définie par une fréquence de fₛ/2, ledit procédé comportant les étapes consistant à :
(a) séparer ledit signal audionumérique en un premier et un deuxième signal audionumérique,
(b) retarder d'une durée prédéterminée ledit premier signal audionumérique,
(c) filtrer par filtrage passe-bande ledit deuxième signal audionumérique, ledit deuxième signal audionumérique, après avoir été soumis au filtrage passe-bande, ayant une première plage de fréquences définie par des fréquences f₁ et f₂ (0 < f₁ < f₂ ≤ fₛ),
(d) étendre ladite première plage de fréquences dudit deuxième signal audionumérique sur une seconde plage de fréquences,
(e) combiner lesdits premier et deuxième signaux audionumériques pour générer un troisième signal audionumérique possédant une plage de fréquences étendue.

2. Procédé selon la revendication 1, dans lequel ladite durée prédéterminée correspond à une durée pendant laquelle ledit troisième signal audionumérique est généré après que ledit signal audionumérique soit séparé à l'étape (a).

3. Procédé selon la revendication 1, comportant en outre une étape consistant à :
ajuster les gains des composantes fréquentielles dudit deuxième signal audionumérique après l'étape (d).

4. Procédé selon la revendication 1, dans lequel ladite fréquence f₁ est égale à fₛ/4 et dans lequel ladite fréquence f₂ est égale à fₛ/2.

5. Procédé selon la revendication 1, dans lequel ladite seconde plage de fréquences est définie par lesdites fréquences fₛ/2 et fₛ.

6. Procédé selon la revendication 1, comportant en outre les étapes consistant à :
(f) décaler les composantes de bruit, qui sont impliquées dans ledit signal audionumérique et qui ont été induites lors de l'émission dudit signal audionumérique par la conversion analogique/numérique, jusqu'à une fréquence dépassant ladite fréquence fₛ avant ladite étape (a),
(g) convertir ledit troisième signal audionumérique en un signal analogique correspondant après ladite étape (e), et
(h) filtrer par filtrage passe-bas ledit signal analogique de manière à bloquer lesdites composantes de bruit.
